Europäisches Patentamt

European Patent Office

Office européen des brevets

(19)

(11) Publication number: **0 402 055**
**A2**

## EUROPEAN PATENT APPLICATION

(21) Application number: **90305973.1**

(22) Date of filing: **31.05.90**

(51) Int. Cl.⁵: **G06F 13/40**

(30) Priority: **09.06.89 US 364742**

(43) Date of publication of application:
**12.12.90 Bulletin 90/50**

(84) Designated Contracting States:
**DE FR GB IT**

(71) Applicant: **International Business Machines Corporation**
**Old Orchard Road**
**Armonk, N.Y. 10504(US)**

(72) Inventor: **Bartol, Thomas Matthew**
**9866 Liberty Court**
**Boca Raton, Florida 33434(US)**

(74) Representative: **Burt, Roger James, Dr.**
**IBM United Kingdom Limited Intellectual**
**Property Department Hursley Park**
**Winchester Hampshire SO21 2JN(GB)**

(54) **Method and apparatus for a rapid interconnection to a computer bus.**

(57) A method and apparatus for rapid interconnection (hot plugging) peripheral device interface circuits to a computer bus is disclosed. The interconnections are completed using three sets of conductors in the sequence: common grounds, power from the bus and data lines. The time period between the interconnections is determined by the relative set back lengths of the conductors from the card edge and allows for stabilization of voltage and establishment of a stable high impedance state for the peripheral device controller circuits before the data lines are interconnected.

FIG. 5

EP 0 402 055 A2

## METHOD AND APPARATUS FOR A RAPID INTERCONNECTION TO A COMPUTER BUS

The present invention relates to a computer system and particularly to a computer system having apparatus for facilitating the rapid interconnection of peripheral device interface circuits to a computer bus to establish both power and two-way data transfer. The interconnection is done in a "hot plug" mode in that neither power nor the data transfer are interrupted during the interconnection of a new peripheral device.

Various methods and apparatus for the rapid interconnection of peripheral device interface or control circuits to computer buses are known in the art. In an effort to minimize the impact of plugging into a bus, the normal procedure has been to shut down the bus so that new devices would not disrupt data flow on the bus. In contrast the hot plugging concept provides both power and data transfer interconnections without causing interruption of ongoing data transfers on the bus. Hot plugging is found in fault tolerant systems which normally include device or field replaceable unit redundancy coupled through operational comparison and checking logic to ensure correct operation.

When a fault is detected an indication of the failing device is provided to service personnel. The failing device is then simply removed from the bus and a replacement device connected. The removal of the failing device and the replacement of a new device are performed without regard to ongoing bus activity. Both the bus architecture and the control device electronics must be carefully designed to achieve this "hot plugging" capability.

The normal control circuits contain electronic microchips mounted on printed circuit boards. A voltage regulator is included on the p.c. board and circuit interconnections to the bus and for power and data transfer are made via edge connectors. Edge connectors are mounted on a printed circuit board which is plugged into a corresponding receptacle for connection to the bus. Plugging in the board makes electrical contact between the edge connectors and the corresponding bus receptacle and thus provides both power to the electronic components on the PC board and interconnects it with the bus in one operation. For hot plugging the normal method of interconnection is to increase the length of at least the ground contact on the edge connector, so that a ground contact can be completed prior to the electrical connection of the other contacts for the application of power and the transfer of data signals. Because of the control of the design parameters of the bus architecture and control circuits hot plugging such circuits into a computer bus ordinarily causes no disruption in the two-way transfer of information on the bus.

Of particular interest is the widening use of the standardized SCSI (Small Computer System Interface) bus. The standard defines the mechanical, electrical, and functional require- ments for a small computer input/output bus and command protocols to enable attaching small computers with each other and with intelligent peripheral devices such as rigid or flexible disks, magnetic tape drives, printers, optical disks and other direct access storage devices (DASD). Such devices will hereafter be referred to as either SCSI compatible devices or more generally as peripheral devices. The primary objective is to provide host computers with device independence within a class of devices to enable a variety of different devices to be added to host computers without requiring modifications to generic system hardware of software.

Several draft specification proposals were presented by the American National Standards for Information Systems, including those dated December 16, 1985 and March 16, 1989. In Section 4.4 of the SCSI specification, there is presented the electrical description for the SCSI bus. The specification allows for the use of TTL technology for the device controllers so that either open collector or tri-state driver devices may be used for interconnecting to the SCSI bus. There are considerable differences in the two types of driver devices since tri-state devices are considerably faster at coming up to operational logic voltage levels than are open collector devices. However, there are many advantages to expanding the types of TTL logic devices which may be connected to the SCSI computer bus. The inclusion of both open collector and tri-state devices for interconnection by a hot plugging method, as will be described later, was discovered to cause operational problems on the SCSI bus. With the widening use of SCSI buses and SCSI compatible devices an attempt was made to use hot plugging techniques on SCSI compatible devices in a fault tolerant environment. The use of SCSI compatible devices in a hot plugging mode would greatly enhance the availability of these devices for fault tolerant operation. However, it was discovered that while many such devices worked with the usual hot plugging technique, some types of SCSI compatible devices disrupted ongoing transfers on the data bus when they were connected.

Thus the problem of hot plugging permitted devices to a SCSI bus has not been encountered before and the prior art methods and apparatus of providing ground contact prior to connecting power and signal to transmit or receive data can in many instances cause disruption of the two-way data flow on the SCSI bus. While the problems were discovered with respect to the two types of TTL devices permitted by the SCSI specification, the problems also exist for hot plugging of NMOs and CMOS implemented peripheral devices, for example, onto a computer bus. There must be a sufficient delay for all peripheral devices to assume a stable high impedance state before data bus connection can begin.

An aim of the present invention is to provide a computer system having apparatus for the rapid interconnection of peripheral devices to and a computer data bus without disrupting the transfer of data on an active bus.

In accordance with the present invention, there is now provided a computer system comprising a computer bus for permitting power and data input/output transfer between a hot system and a pluggable peripheral device controller circuit and apparatus for the rapid interconnection of a multi-conductor connector of the controller circuit to the computer bus without disrupting any data transfers occurring on the computer bus; the apparatus comprising: means for connecting ground terminals of the controller circuit to the corresponding conductors of the computer bus for permitting the power and input/output transfer; means for connecting power teminals of the controller circuit to corresponding conductors of the computer bus for supplying a voltage to the controller circuit subsequent to the connection of the ground terminals; characterised in that the apparatus further comprises: means for delaying for a first predetermined period further connection until the voltage within the controller circuit reaches a stable state and for the controller circuit to establish a stable high impedance state; and means for connecting data input/output terminals of the controller circuit to the data bus after the first predetermined period. Preferably, the computer system includes means for delaying the connection of power to the controller circuit for a second predetermined time until any voltage transients introduced in the computer bus by the connection thereto of the controller circuit ground terminals have .substantially decayed. In a preferred arrangement, the multi-conductor connector comprises: an edge connector having a parallel arrangement of plural conductors of a plurality of different lengths for establishing sequential electrical interconnections with corresponding receptacles of the computer bus; the conductors of the longest length being coupled to the controller circuit ground terminals for providing a first electrical interconnection; the conductors of an intermediate length being coupled to the controller circuit power terminals for providing an intermediate interconnection which occurs subsequent to the first interconnection; and the conductors of the shortest length being coupled to the controller circuit data input/output terminals for providing a final interconnection which occurs after the second interconnection. In anther prefered arrangement, the edge connector comprises a parallel arrangement of conductors of three different lengths chosen for providing the predetermined time delays between the interconnection of the various terminals of the controller circuit to the various receptacles of the computer bus during the rapid interconnection of the multi-conductor connector of the controller circuit.

Viewing the present invention from a second aspect, there is now provided an apparatus for the rapid interconnection by means of a multi-conductor connector for a peripheral device controller circuit to both power and a computer data bus without disrupting ongoing data transfers on an active bus is described as comprising: means for interconnecting the ground terminals for power and data input/output; means for interconnecting power to the controller circuit subsequent to the interconnection of the grounds; means for delaying for a predetermined time further interconnections until stabilization of voltage on the controller circuit and for the controller circuit to establish a stable high impedance state; and means for interconnecting data input/output terminals of the controller circuit to the data bus after the predetermined time. Preferably, the first predetermined time is determined by the time required for the voltage on the controller circuit to stabilize to within 10% of its nominal value. In a prefered arrangement, the first predetermined time is determined by the time required for the voltage on the controller circuit to stabilize to within 1% of its nominal value. In another prefered arrangement, the apparatus further includes means for delaying the interconnection of voltage to the controller circuit for a second predetermine time or until the stabilization of any voltage transients included into the computer bus by the inter- connection of the controller circuit grounds.

Viewing the present invention from a third aspect, there is provided an apparatus for the hot plugging of a peripheral device controller circuit to a SCSI computer bus, the bus providing both power and data transfer, without disrupting data transfers on an active bus, comprising: edge connector means for interconnection with a corresponding receptacle having parallel arrangement of plural conductors, of three different lengths for establishing sequential electrical interconnections; the longest length of conductors being coupled to the controller circuit grounds terminals for providing a first electrical interconnection; the intermediate length conductors, being coupled to the power teminals of the controller circuit to provide a second electrical interconnection which occurs subsequent to the first inter- connection; and the shortest length conductors being coupled to the data input/output terminals of the controller circuit to provide a third electrical interconnec- tion which occurs subsequent to the second interconnection. Preferably, the relative lengths of the longest, intermediate and shortest conductors are chosen to provide predetermined time delays between intercon- nections of the various terminals to the computer bus.

Viewing the present invention from a fourth aspect, there is now provided, a peripheral direct access storage device controller printed circuit card containing electronic logic circuits electrically interconnected to control the device and including an apparatus for hot plugging the card into a Small Computer System Interface (SCSI) bus to provide both power and data input/output transfer, comprising: a parallel arrangement of a plurality of edge conductors on the printed circuit card, electrically interconnected to the electronic logic circuits, the conductors being of three distinct set back lengths from the edge of the printed circuit card for establishing sequential electrical intercon-nections, of the card to the bus. Preferably, the sequential electrical interconnections are chosen to interconnect common grounds, power from the SCSI bus, and data lines.

Viewing the present invention from a fifth aspect, there is now provided,a method of rapid interconnection by means of a multi-conductor connector for peripheral controller circuits to a computer bus which provides both power and data transfer without disrupting on ongoing data transfers on an active bus is described as comprising in sequence: interconnecting the ground terminals for power and data input/output transfer; interconnecting power to the controller circuit; waiting a period of time for voltage on the controller circuit to stabilize and for the controller circuit to establish a stable high impedance state; and interconnecting the data input/output terminals of the controller circuit to the data bus. Preferably, the method includes after the step of waiting a period of time, the further step of waiting and additional period of time approximately five times the length of the first waiting period for additional voltage stabilization on the controller circuit and an establishment of a more stable high impedance state. In one prefered arrangement, the method includes after the step of interconnecting the grounds, the further step of waiting a period of time to allow for stabilization of any voltage transients induced into the power line and computer bus by the interconnection of the controller circuit grounds. In another prefered arrangement, the method includes after the step of interconnecting the grounds, the further step of waiting a period of time to allow for stabilization of any voltage transients induced into the power line and computer bus by the interconnection of the controller circuit grounds.

In a prefered embodiment of the invention to be described later, there is provided an apparatus to enable the hot plugging of any specified peripheral direct access storage device to a standardized Small Computer System Interface (SCSI) bus without disrupting the ongoing transfers of data on an active bus.

An example of the present invention will now be described with reference to the accompanying drawings in which:

Figure 1 shows a block diagram form the interconnection of several peripheral devices and controllers to a SCSI bus for a single computer.

Figure 2 shows an edge connector mounted on a controller logic circuit PC board and a corresponding mating connector for interconnection with a computer data bus.

Figures 3A and B show examples of the electrical schematics for open collector and tri-state TTL type controller circuits for computer peripheral devices.

Figures 4A and B show respectively the voltage versus time traces for the voltage regulator on a typical controller circuit and the voltage trace at the data output terminals of a controller circuit mating with a computer bus.

Figure 5 shows the electrical conductor tab arrangement for an edge connector for a controller circuit employing the present invention and the corresponding interconnection times.

## DESCRIPTION OF THE PREFERRED EMBODIMENT

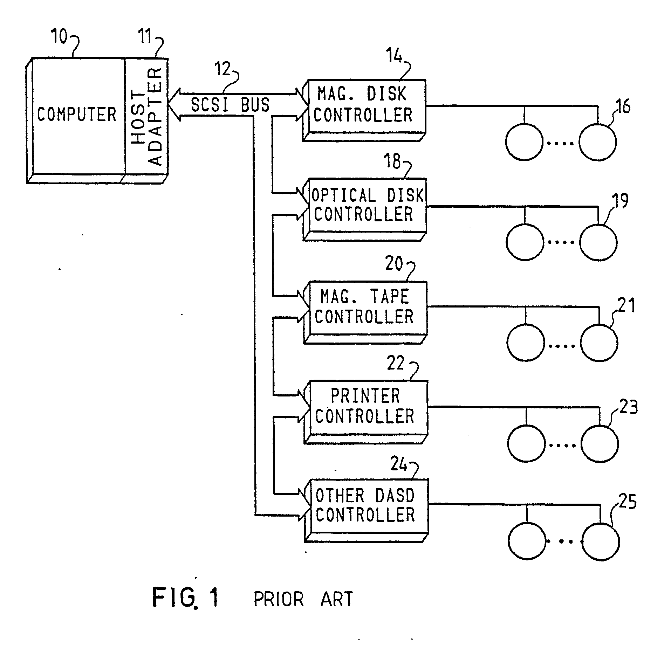

Figure 1 shows in block diagram form the interconnection of several peripheral devices via a SCSI bus to a single computer. In particular, a computer 10 with host adapter 11 is shown to be interconnected with a SCSI bus designated 12. Also, coupled to bus 12 is a magnetic disk controller 14 and a plurality of magnetic disk devices generally designated as 16. In a similar manner, optical disk controller 18 and a plurality of optical disks 19 are shown coupled to the bus along with magnetic tape controller 20 and a plurality of magnetic tape drives 21, printer controller 22 and a plurality of printers 23, and other direct access storage device (DASD) controller 24 along with a plurality of DASD devices 25. Each of the controller devices may have one or more storage devices coupled to them. In general, based upon a requirement of computer 10 during it's normal course of operation under control by an application program, information and requests go on the bus 12 to the SCSI compatible devices via the appropriate controllers to either store or retrieve information from the storage device.

Figure 1 will be recognized by those skilled in the art as the ordinary interconnection of a generalized computer interface bus with appropriate peripheral storage devices and the environment in which the present invention may be utilized. The problem presented is one of providing a method and apparatus to enable the hot plugging of compatible interface or controller circuits for computer peripheral devices to a generalized computer bus and more specifically to a SCSI bus.

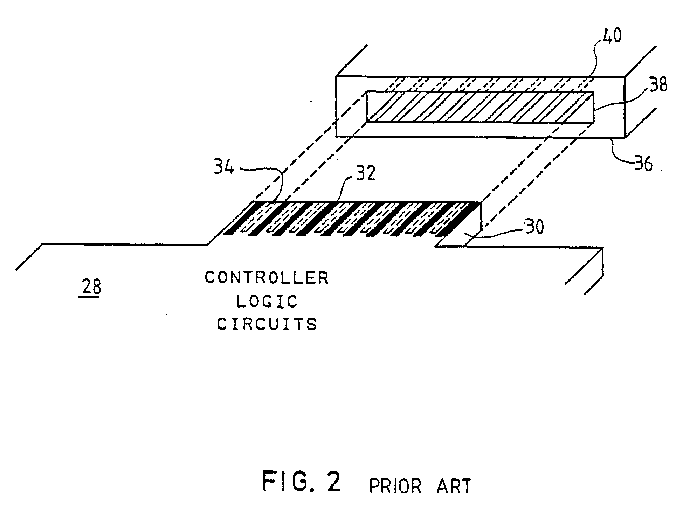

Figure 2 shows a printed circuit card 28 supporting peripheral device controller logic circuits (not shown) having an edge connector which comprises a series of parallel electrical conductors 32 and 34 which may be mounted on either or both sides of the printed circuit board. Adjacent to the edge connector portion 30 of the printed circuit card 28 is a corresponding or mating connector 36 coupling the individual parallel electrical connectors 32 and 34 on the card to the appropriate interconnections 40 and 42 on the computer data bus. Figure 2 is an example of the interconnection of controller cards for many such computer bus devices and is clearly well known to those skilled in the art. The insertion of the card into the appropriate or mating connector slot 38 coupled to a computer bus including a SCSI bus causes the electrical interconnection of all of the controller logic circuit conductors on the printed circuit card with the SCSI bus. These normally include power, data and ground connections for the controller circuit. It is thus the preferred way of interconnecting controller cards for peripheral devices to computer buses.

Unlike specially designed computer interface buses which permit the hot plugging of field replaceable units, such as direct access storage devices and their appropriate controller circuits, the SCSI bus permits the use of two types of TTL devices, which have substantially different electrical characteristics. Thus, it has been discovered that in an effort to provide a standardized interface bus, the SCSI bus includes provisions for types of transistor to transistor logic which would ordinarily prevent a hot plugging capability from being implemented with the SCSI bus. In section 4.4. of the SCSI specification, more than one type of TTL logic has been specified for utilization with the SCSI interface bus. In an effort to understand the background for this problem, a review of the two types of transistor to transistor logic types, namely open collector and tri-state devices is included.

In general, there are only two steady state output conditions on a TTL gate. The output low state is within a few tenths of a volt of ground and it is called a "positive logic 0". In this state the output is capable of sinking a considerable current.

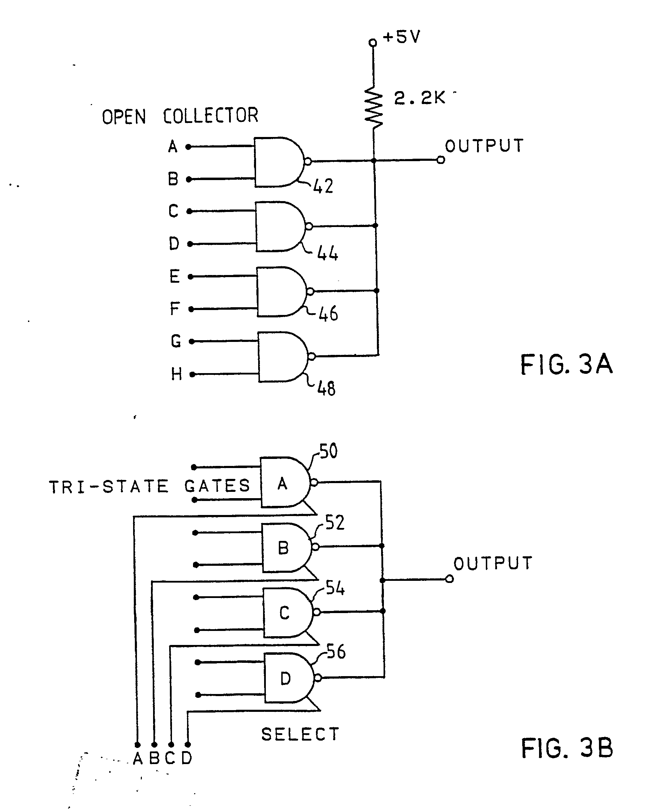

The output high state is above 2.4 volts and it is called a "positive logic 1". The output high state is well below the standard 5 volt positive supply of voltage. When a TTL gate is provided with an open collector output, it is referred to as open collector logic device. These gates may be connected to other open collector output gates to perform additional logic. Both Figs. 3A and 3B, and the corresponding attributes and limitations of normal operation are well known to those skilled in the art. The two device types are presented here to show the diversity of TTL logic circuits which may interface with a SCSI bus.

Figure 3A shows four NAND gates designated 42, 44, 46 and 48 having common outputs coupled together to a terminal labeled output and through a 2.2K resistor to a source of +5 volt. The TTL gates arranged in the manner shown form an open collector logic circuit. The systems speed can suffer as inclusion of a pull-up resistor at the output does slow the output rise time. Such open collector devices tend to show a sensitivity to an input noise problem and because of the pull-up resistor cannot hope to be as fast as a device operating as an individual gate. In addition, with such a logic arrangement there is no easy way to find a faulty part without removing or separating devices since the outputs are tied together.

By contrast, Fig. 3B shows four AND gates designated 50, 52, 54, and 56 arranged in the manner shown to form a tri-state device. Each AND gate has two distinct input terminals and their outputs are all coupled together to a common output. In addition, each of the AND gates has a select or enable input terminal coupled to the device. Tri-state or three state logic has been suggested to overcome some of the speed limitations of open collector devices, but at a somewhat higher price. Operationally tri-state devices come up to output levels after power is applied many times faster than do open collector devices. The third state of tri-state logic is an open circuit. Any tri-state device has an output enable control which when activated causes the output to behave as an ordinary TTL gate, with either an active pull-up for logic one or a current sinking pull down for a logic 0. In the third state the internal circuitry is essentially disconnected from the output which is then allowed to assume a high impedance state, thus making the circuit essentially transparent to anything connected to the output.

Each peripheral device controller card is provided with suitable electronic logic circuits to interface the peripheral device with the computer bus and engage in transfers of data and other information. To insure proper voltage at the logic circuits the controller card contains a power regulator which interconnects with the power connections of the computer bus to provide regulated voltage for the logic on the card. The hot plugging of controller cards not only involves the speed with which the TTL logic devices become operational after the application of power, but also the normal voltage rise time for the card mounted regulator to assume a nominal voltage. By contrast, the rise time of the logic is a function of the type of TTL logic employed. In a similar manner, the time required to achieve a stable high impedance state would also be a function of an NMOS or CMOS circuit implementation for the peripheral device.

Hot plugging requires a non-interference with the active or ongoing data transfer that exists on the bus when a device is plugged in or unplugged. The designers of a total data bus system can ensure that a particular bus will meet the design criteria by restricting the device controllers that are allowed on the bus such as by permitting only open collector type TTL devices. This is not possible on the SCSI bus and indeed the SCSI specification allows different manufacturers of SCSI compatible devices to use different logic devices with different characteristic impedances. The hot plugging problem that has been observed is that false signal levels can be impressed on the bus especially during the power-on phase for TTL devices. This is the time when it was discovered that the controller circuit voltage is not fully regulated and the switching levels of the devices are such that output lines may start to oscillate between high and low TTL levels until the voltage is stabilized. If these devices were connected to an active data bus, errors would be injected onto the bus.

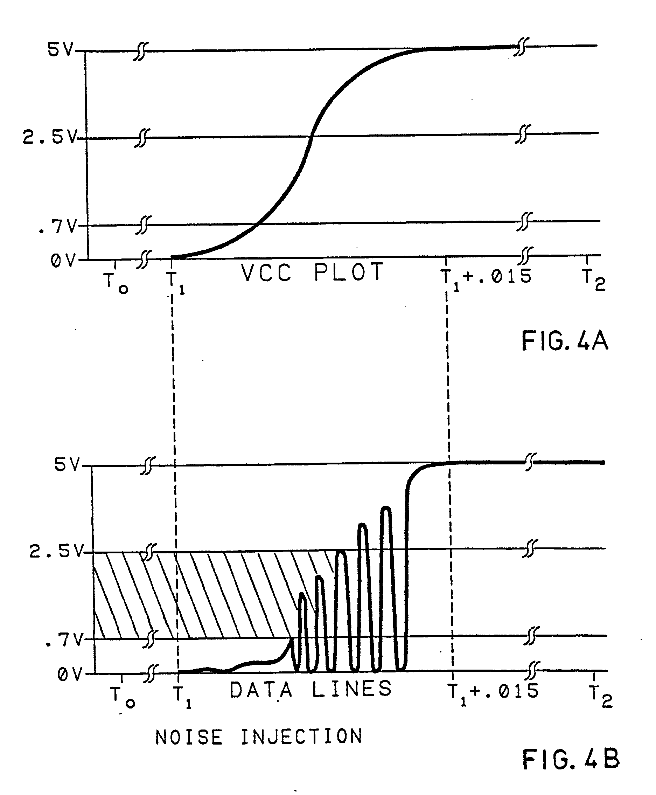

Figure 4A shows the voltage versus time traces for a standard voltage regulator normally mounted on the device controller card. Upon power connection to the computer bus the voltage regulator for the controller circuit comes into regulation in a well known manner. When the power is applied to the controller logic circuits at time T1 the voltage for the logic circuits begins to rise from a 0 voltage level. The trace shows four principal ordinate values, 0 volts, .7 volts, 2.5 volts, and 5 volts. Voltages at the output terminals of the logic circuits between 0 and .7 volts will be determined as a "logic 0" and voltage levels at output terminals between 2.5 and 5 volts will be determined to be a "logic 1". The region between .7 volts and 2.5 volts is an undefined band gap region for which voltages will not be treated as either logic 1's or 0's. It is thus a logic indeterminate region. Continuing with the description of the trace, at time T1 when voltage is applied from the bus, the voltage output of the voltage regulator on the controller circuit begins to increase as a function of time. The trace shows the voltage output for the regulator on a control card continues to increase until approximately .015 sec. from application of power from the bus, the regulator has achieved its nominal 5 volts output preferably to within 10% of nominal value. This is a function of the electronics of the regulator which is standard and normally provided for either open collector or tri-state devices controller cards. If voltage from the on card regulator were supplied to the logic circuits at time T2 the voltage would be more stabilized preferably to within 1% of its 5v nominal value and the logic circuits would have achieved a stable high impedance state.

Figure 4B shows the voltage verses time trace for the output data lines of a tri-state controller logic circuit. The same four principal ordinate values of voltage are shown but not the band gap region from .7v to 2.5 volts is shown cross hatched for emphasis. At T1, when power is applied from the bus, the voltage regulator responds as shown in Fig. 4A and so do the tri- state output data lines as shown in Fig. 4B. During the time interval from T1 to T1 + .015 sec. there is a ringing phenomenon observed especially for the tri-state output devices. This produces short term spurious signals on the bus which are variously in the "logic 0", band gap and "logic 1" ranges. None of these impressed output values is valid and results only from the propagation of transients through the tri-state controller card logic circuits. Thus, during hot plugging, ongoing data transfers on an active bus can be totally disrupted by the hot plug connection of a new tri-state implemented SCSI compatible device. Subsequent to time T1 + .015 sec. when the voltage regulator is within 10% of its nominal value the output lines will have stabilized, in this case the levels are shown to be at logic 1 and there is a very small probability that disruptions would be caused on the bus. If the time to enable the activation of data lines was delayed until T2, the point at which the voltage regulator was within 1% of its nominal value, then there would be no problem with the completion of the hot plugging.

The normal method for hot plugging controller cards in a fault tolerant environment using TTL logic is to utilize the practice of increasing the length of the ground connectors so that when a controller card is plugged in, ground connections are made first and then all other connections to apply power to the regulator and activate the logic circuits. The circuit designer has complete control over the design of the fault tolerant computer bus being implemented and can select or reject logic devices accordingly. But with a standardized bus, such as the SCSI bus, the designer is limited in which types of logic circuits for peripheral devices he can select or reject. Assurance must also be provided so that the design does not interfere with ongoing bus operations during hot plugging.

The first attempt at a solution following normal fault tolerant techniques, was to allow ground interconnections to occur first and to adjust and voltage/power connections so that they occur simultaneously. However, this causes disruption in the power level on the bus because of excessive loading and subsequently causes data errors on the bus. Signal levels on the bus can be lowered to a point that other devices may be completely disengaged from the bus, thus completely disrupting data transfer and further causing start up rise time disruption when they try to come back on line.

The second attempt at a solution was to adjust the data connections so that the ground and data interconnections occur simultaneously. This causes excessive loading and disruption of the data transfer on the bus immediately. Applying power subsequently cannot resolve the problem since the damage has already been done.

The solution has been found to be sequentially connecting the grounds, power and data lines for controller cards exhibiting the delay of .015 sec. as indicated in the discussion for Fig. 4B. Thus as shown in Figures 4A and 4B, To: would correspond to the ground interconnection; T1: the application of voltage from the bus: T1 + .015 sec. would correspond to voltage regulation to within 10% of nominal value; T2: would correspond to voltage regulation to within 1% of nominal value; and the interval T2-T1 would preferably be .090 sec. or approximately 6 times the .015 sec. interval. This is most easily implemented electronically by placing logic transmission gates or other suitable switches at all of the control circuit data line connections and delaying the enabling of those transmission gates until the voltage regulator has reached its steady state value and assumed a high impedance level a time delay device controlling the switches would have to work properly during the entire power up operation. This could be to either the 10% or 1% nominal values. However, considerable real estate on the controller circuit board would be required to implement this solution. It may also cause difficulty in identifying and isolating the fault source in fault tolerant designs. A considerably simpler solution has been achieved by the careful utilization of the differential length connectors of the type used to implement normal hot plugging of peripheral devices with a fault tolerant bus.

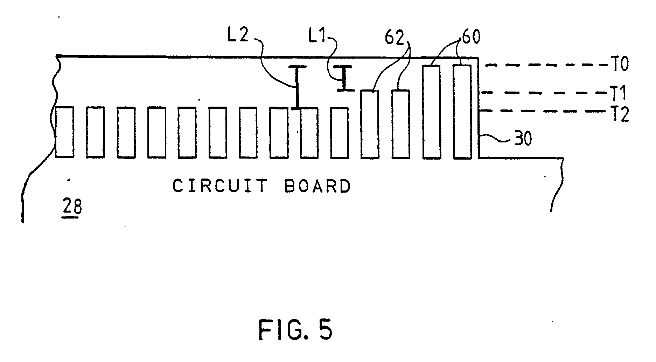

Figure 5 shows the preferred embodiment for the present invention. It comprises an apparatus which is conjunction with a method for interconnecting SCSI compatible devices allows for hot plugging in any environment especially a fault tolerant one. The connector portion 30 of a PC controller card is shown with three sets of conductive strips having different lengths. Conductors 60 are utilized for the ground interconnections, and form the base line from which length measurements are made.

Conductors 62 are utilized for the power interconnections and are spaced at a distance L1 from the base line of the ground conductors 60 and conductors 64 are utilized for the controller data line interconnections and are positioned at a distance L2 from the base line of ground conductors 6.0. The relative lengths are chosen so that for a reasonable insertion force, sufficient time elapses between the interconnection of conductors 62 and the subsequent interconnection of conductors 64 so that sufficient to eliminate all transients and establish a stable high impedance state has elapsed.

As shown in Fig. 5 the ground conductors 60 interconnect with the bus at time To; the power conductors 62 at time T1 and the data line conductors at a time greater than T1. As for normal fault tolerant interconnections the time between T1 and To is not critical but should be sufficient to assure all ground lines in the logic circuits have reached the computer ground. For the TTL logic system a minimum of .015 sec. has been found to be acceptable for the difference between T1 and T2 but a time difference of .090 is preferred. The lengths for conductors 60, 62 and 64 are chosen to establish interconnections at times T0, T1 and T2 respectively. In the preferred embodiment the lengths are L1: 1.78 mm (0.070 in) and L2: 2.54 mm (0.100 in) relative to the ground conductors 60 base line.

Thus, regardless of which of the allowable types of logic circuitry are used for the device interface controller, the conductive contacts are arranged to permit the grounds to be connected first then, power to voltage regulator on the controller card, and after a suitable time for the settling of transients as shown in Fig. 4B, the data input and output connections to the SCSI bus are connected. In this way no transient signals from the electronic circuitry for the controller card will be impressed on the data bus nor can there be an inordinate electrical loading provided to the bus. This provides a simple yet elegant solution to the problem of providing a hot plugging capability of devices which are compatible with a SCSI bus. While the preferred embodiment has shown the implementation for two types of TTL logic it will be clear to those skilled in the art that the invention may be used for other implementations including differences in NMO and CMOS implemented peripheral devices which also exhibit the phenomena of having different times to come up to full voltage, and the possibility of excessive loading on a bus and clear transient signals during power on.

**Claims**

1. A computer system comprising a computer bus (12) for permitting power and data input/output transfer between a host system (10,11) and a pluggable peripheral device controller circuit (14) and apparatus for the rapid interconnection of a multi-conductor connector (30) of the controller circuit (14) to the computer bus (12) without disrupting any data transfers occurring on the computer bus (12); the apparatus comprising:

means (60) for connecting ground terminals of the controller circuit (14) to the corresponding conductors of the computer bus (12) for permitting the power and input/output transfer;

means (62,L1) for connecting power terminals of the controller circuit (14) to corresponding conductors of the computer bus (12) for supplying a voltage to the controller circuit (14) subsequent to the connection of the ground terminals;

characterised in that the apparatus further comprises:

means (L2) for delaying for a first predetermined period further connection until the voltage within the controller circuit (14) reaches a stable state and for the controller circuit (14) to establish a stable high impedance state; and

means (64) for connecting data input/output terminals of the controller circuit to the computer bus (12) after the first predetermined period.

2. A computer system as claimed in claim 1 including means for delaying the connection of power to the controller circuit for a second predetermined time until any voltage transients introduced in the computer bus by the connection thereto of the controller circuit ground terminals have substantially decayed.

3. A computer system as claimed in claim 1 or claim 2 wherein the first predetermined time is determined by the time required for the voltage within the controller circuit to stabilise to within ten per cent of its nominal value.

4. A computer system as claimed in claim 1 or claim 2 wherein the first predetermined time is determined by the time required for the voltage within the controller circuit to stabilise to within one per cent of its original value.

5. A computer system as claimed in any preceding claim wherein the computer bus is a Small Computer System Interface bus.

6. In or for a computer system as claimed in any preceding claim, a peripheral device controller circuit supported by a pluggable printed circuit board comprising apparatus for the rapid interconnection of a multi-conductor connector of the controller circuit to the computer bus without disrupting any data transfers occurring on the computer bus; the multi-conductor connector comprising:

an edge connector having a parallel arrangement of plural conductors of a plurality of different lengths for establishing sequential electrical interconnections with corresponding receptacles of the computer bus;

the conductors of the longest length being coupled to the controller circuit ground terminals for providing a first electrical interconnection;

the conductors of an intermediate length being coupled to the controller circuit power terminals for providing an intermediate interconnection which occurs subsequent to the first interconnection; and

the conductors of the shortest length being coupled to the controller circuit data input/output terminals for providing a final interconnection which occurs after the second interconnection.

7. Apparatus as claimed in claim 6 wherein the edge connector comprises a parallel arrangement of conductors of three different lengths chosen for providing the predetermined time delays between the interconnection of the various terminals of the controller circuit to the various receptacles of the computer bus during the rapid interconnection of the multi-conductor connector of the controller circuit.

8. A peripheral device controller printed circuit card comprising apparatus as claimed in claim 7.

9. A peripheral direct access storage device controller printed circuit card comprising apparatus as claimed in claim 7.

10. A peripheral device controller printed circuit card as claimed in claim 8 or claim 9 wherein the apparatus is operable for coupling with a Small Computer System Interface bus.

11. In a computer system, a method of rapid interconnection by means of a multi-conductor connector for connecting peripheral device controller circuits to a computer bus which provides, without disrupting data transfers on an actual bus, both power and data input/output transfer, comprising in sequence the steps of:

interconnecting the ground terminals for power and data input/output transfer;

interconnecting power to the controller circuit;

waiting a period of time for the voltage on the controller circuit to stabilise and for the controller circuit to establish a stable high impedance state; and

interconnecting the data input/output terminals of the controller circuit to the data bus.

12. A method as claimed in claim 10 including after the step of interconnecting the grounds, the further step of waiting a period of time to allow for stabilisation of any voltage transients induced into the power line and computer bus by the interconnection of the controller circuit grounds.

13. A method as claimed in claim 11 or claim 12 wherein the computer bus is a Small Computer System Interface Bus.

FIG. 1   PRIOR ART

CONTROLLER
LOGIC
CIRCUITS

28

FIG. 2  PRIOR ART

OPEN COLLECTOR

FIG. 3A

TRI-STATE GATES

FIG. 3B

VCC PLOT

FIG. 4A

DATA LINES

NOISE INJECTION

FIG. 4B

FIG. 5